# EUROPÄISCHE PATENTSCHRIFT

(11) **EP 0 712 007 B1**
(45) Veröffentlichungstag und Bekanntmachung des Hinweises auf die Patenterteilung: **15.09.1999**
(21) Anmeldenummer: 95119896.9
(22) Anmeldetag: 30.07.1992
(51) Int. Cl.: G01R 31/36, H02J 7/00, B26B 19/00

(54) **Batteriebetriebener elektrischer Rasierapparat oder Haarschneidemaschine**
Battery operated electric razor or hair clippers
Rasoir électrique ou tondeuse capillaire fonctionnant sur pile

(30) Priorität: 26.09.1991 DE 4131981
(43) Veröffentlichungstag der Anmeldung: 15.05.1996
(62) Teilanmeldung aus: 92916258.4
(73) Patentinhaber: Braun Aktiengesellschaft, Frankfurt am Main (DE)
(72) Erfinder: Lang, Gerhard, D-61276 Altweilnau (DE); Wolf, Jürgen, c/o Braun Espanola, S.A., E-08950 Esplugues Del Llobregat (Barc.) (ES)

(56) Entgegenhaltungen:
- EP-A- 0 240 883
- US-A- 4 342 953
- US-A- 4 703 247

## Beschreibung

Die Erfindung betrifft einen batteriebetriebenen elektrischen Rasierapparat oder eine Haarschneidemaschine mit einer Detektion des Entladezustandes der Batterie.

Batteriebetriebene elektrische Geräte, insbesondere Geräte des Konsumgüterbereichs, wie aufladbare Rasierapparate, werden in zunehmendem Maße mit Displays versehen, die den aktuellen Ladezustand der Batterie oder des Akkumulators anzeigen. Solche Ladezustandsanzeigen erfolgen aus Kostengründen meist auf Zeitbasis, da solche Geräte einen im wesentlichen konstanten Stromverbrauch (konstante Leistung) haben und die Nennkapazität der Batterie bekannt ist.

Aus der US-A-4,703,247 sind mehrere Schaltungen zur Anzeige des Ladezustands der Batterie eines elektrischen Rasierers bekannt, die dem Benutzer, kurz bevor die Batterie völlig entladen ist, einen entsprechenden Hinweis geben. Ein solcher Hinweis ist das Abschalten des Rasierermotors oder die Absenkung der Versorgungsspannung und damit der Motordrehzahl auf einen Wert ungleich "Null". Durch Betätigen eines Schalters 17; 26 kann der Motor mit voller Drehzahl bis zum unkontrollierten völligen Zusammenbruch der Batteriespannung weiter betrieben werden.

Aus der US-A-4,342,953 und der EP-A-0240883 ist es bekannt, eine batteriebetriebene Leuchte zwecks Tiefentladungsschutz in zwei Schritten von der Batterie zu trennen, wobei beim ersten Schritt die der Leuchte zugeführte elektrische Energie reduziert, und beim zweiten Schritt, d.h. bei Erreichen eines bestimmten Spannungs-Schwellwerts, die Leuchte einfach abgeschaltet wird.

Aufgabe der Erfindung ist es, einen Rasierapparat oder eine Haarschneidemaschine so auszugestalten, daß bei sich entladender Batterie verhindert wird, daß der Motor schlagartig stehen bleibt, was störend wäre, weil Haare eingeklemmt werden könnten.

Vorteilhaft zeigt sich bei dem Gegenstand des Anspruches 1, daß sich für den Benutzer ein Gebrauchsvorteil des Rasierapparates bzw. der Haarschneidemaschine einstellt, und darüberhinaus die Batterie vor Tiefentladung geschützt wird.

Ist der elektrische Verbraucher ein Gleichstrommotor, besteht eine vorteilhafte Ausgestaltung der Erfindung darin, daß zur Abschaltung des Motors ein Pulsbreitenmodulator angesteuert wird, der das Tastverhältnis der Steuerspannung für einen elektronischen Schalter reduziert, über den der Motor an die Batterie angelegt wird, so daß die Motordrehzahl stufenweise oder kontinuierlich bis auf Null reduziert wird.

Weitere vorteilhafte Ausgestaltungen sind den übrigen Unteransprüchen und der Beschreibung entnehmbar.

Die Erfindung wird im folgenden an Hand von in der Zeichnung dargestellten Ausführungsbeispielen näher beschrieben.

Es zeigen:
- Fig. 1: ein Blockschaltbild,
- Fig. 2: ein Ausführungsbeispiel mit einem Motor als elektrischen Verbraucher,
- Fig. 3: ein Ausgangssignal des Pulsbreitenmodulators in Fig. 2, wenn die Drehzahl des Motors entsprechend einer fallenden Batteriespannung verringert wird,
- Fig. 4: die Motordrehzahl bei Steuerung des Tastverhältnisses des Pulsbreitenmodulators entsprechend Fig. 3.

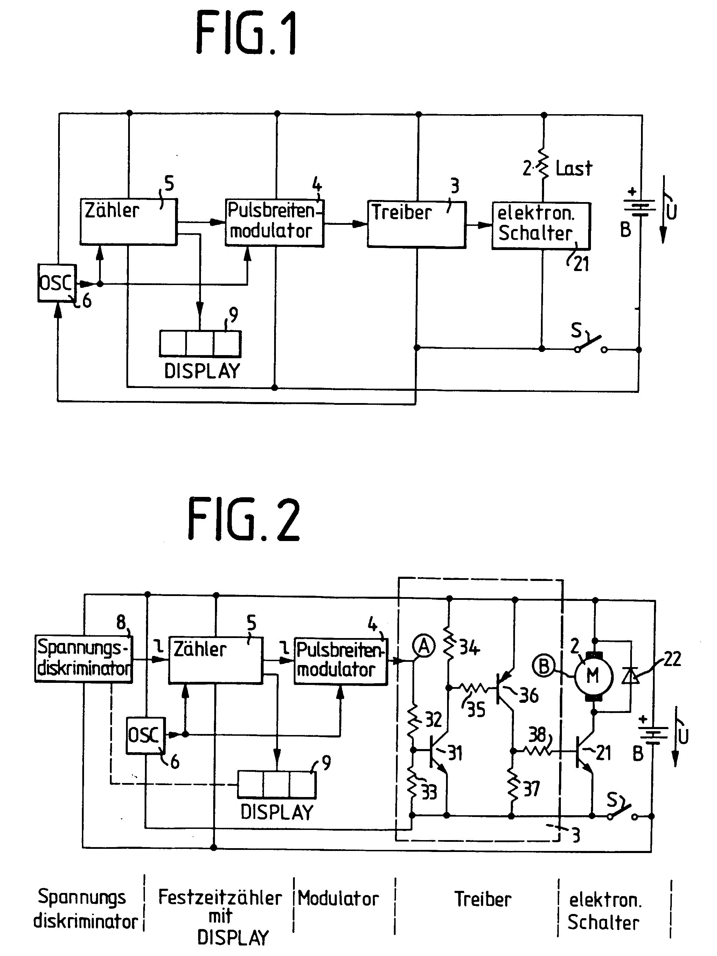

In Fig. 1 wird über einen Ein-/Ausschalter S und über einen elektronischen Schalter 21 die Last (der Verbraucher) 2 an die Batterie (Akkumulator) B geschaltet. Die Batterie B kann über eine nicht dargestellte Ladeschaltung aufgeladen werden. Der elektronische Schalter 21 wird über eine Treiberschaltung 3 von einem Pulsbreitenmodulator 4 angesteuert.

Der Zähler 5 registriert die Anschlußzeit der einen im wesentlichen konstanten Stromverbrauch aufweisenden Last L über den Schalter S an die Batterie B ab vollgeladener Batterie.

Da auch die Nennkapazität der Batterie B bekannt ist, wird das den Ladezustand der Batterie anzeigende Display 9 auf Zeitbasis vom Zähler 5 gesteuert. Wenn eine vorgegebene Anschlußzeit vergangen ist, die auf Grund des bekannten Stromverbrauchs und der bekannten Nennkapazität der Batterie B derart bestimmt wird, daß die Batterie dann nur noch wenig Ladung enthält, gibt der Zähler 5 ein Ausgangssignal ab. Zu diesem Zeitpunkt zeigt das Display 9 den Ladezustand "Null" an. Dieses Signal bewirkt, daß der elektronische Schalter 21 angesteuert wird. Diese Ansteuerung kann über einen Pulsbreitenmodulator 4 erfolgen, der das Tastverhältnis der Steuerspannung allmählich bis auf Null reduziert und so den durch die Last 2 fließenden Strom allmählich verkleinert. Der Oszillator 6 stellt die Taktimpulse für den Zähler 5 und den Pulsbreitenmodulator 4 bereit.

In Fig. 2 ist der Verbraucher (die Last) 2 ein Gleichstrommotor M, beispielsweise eines elektrischen Rasierapparates. Die Serienschaltung des Motors M mit dem Schalttransistor 21 wird über den Ein-/Ausschalter S bei Inbetriebnahme an die Batterie B gelegt. Die zum Motor M parallel geschaltete Diode 22 verhindert induktive Spannungsspitzen. Die Basis des Schalttransistors 21 wird über eine aus den Transistoren 31, 36 und den Widerständen 32, 33, 34, 35, 37, 38 bestehende Treiberschaltung 3 vom Ausgang des Pulsbreitenmodulators 4 angesteuert.

Der Batterie B ist ein Spannungsdiskriminator 8 und der Zähler 5 direkt parallel geschaltet, das heißt nicht über den Ein-/Ausschalter S. Der Spannungsdiskriminator 8 detektiert eine bestimmte Spannung U an der Batterie B. Diese detektierte Spannung U ist beispielsweise der sogenannte "low charge" Punkt, das ist eine an der Batterie anstehende Spannung U, wenn die Batterie nur noch 10 bis 20% ihrer Ladung enthält. Bis zum Erreichen dieses low charge Punktes zeigt das Display 9 den auf Grund der vergangenen Anschlußzeit des Motors M an die Batterie B den Ladezustand an.

Hat der Spannungsdiskriminator 8 den low charge Punkt der Spannung U an der Batterie B detektiert, wird der Zähler 5 und eine zweite Anzeigeeinheit des Displays 9 gestartet. Wenn der detektierte low charge Punkt erreicht ist, kann der Motor beispielsweise nur noch 8 Minuten bis zur vollständigen Entladung der Batterie B betrieben werden. Die für den Zähler 5 vorgegebene Zeit beträgt nun beispielsweise 6 Minuten, um eine vollständige Entladung der Batterie mit Sicherheit zu verhindern. Diese 6 Minuten können in sechs feste, gleichgroße Zeitintervalle unterteilt werden, so daß jede Minute ein Segment der zweiten Anzeigeeinheit des Displays 9 angesteuert wird. Diese Segmente können auch die noch verbleibenden Minuten bis zum Ablauf der vorgegebenen Zeit anzeigen. Nach Ablauf der vorgegebenen Zeit (6 Minuten), das heißt wenn der Zähler 5 auf Null angelangt ist, wird der Pulsbreitenmodulator 4 angesteuert.

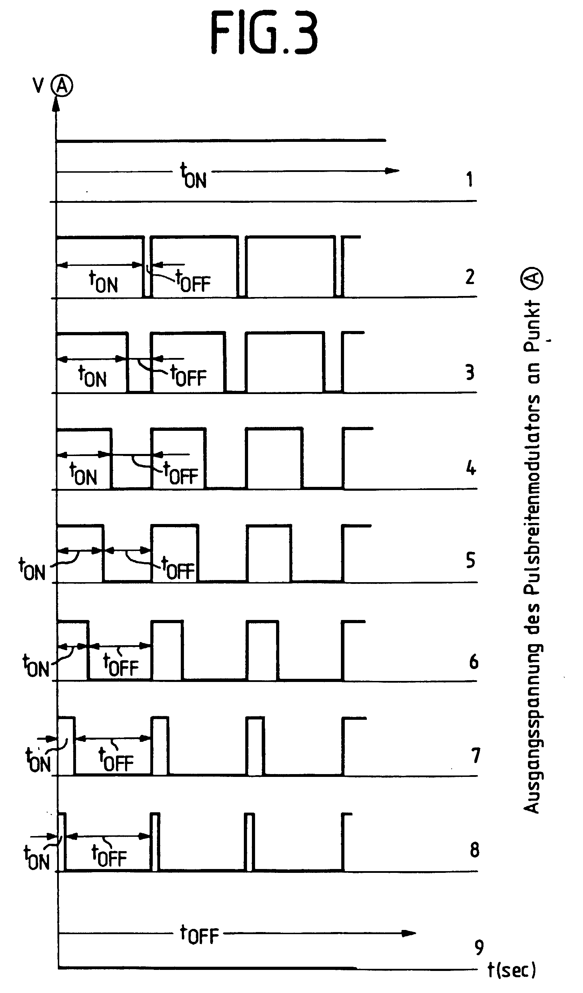

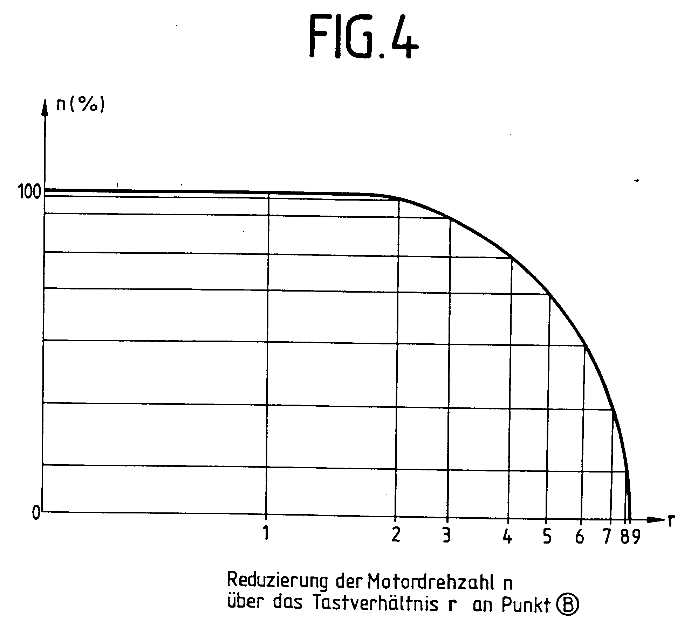

Dieser Pulsbreitenmodulator 4 reduziert das Tastverhältnis der dem Treiber 3 zugeführten Steuerspannung auf eine beispielsweise in Fig. 3 dargestellte Weise. Die verschiedenen Tastverhältnisse in Fig. 3 sind mit Ziffern von 1 (volle Steuerspannung) bis 9 (Steuerspannung Null) versehen. In Fig. 4 ist nun die Motordrehzahl (in % der Nenndrehzahl) in Abhängigkeit dieser Tastverhältnisse dargestellt, wobei die mit den Ziffern 1 bis 9 angegebenen Tastverhältnisse denen in Fig. 3 entsprechen. Diese Kurve entspricht im wesentlichen dem Verlauf der Spannung einer Batterie bei angeschaltetem Verbraucher bis zur vollständigen Entladung.

Auf diese Weise wird eine Tiefentladung der Batterie verhindert. Infolge des nicht abrupten Stillstands des Motors wird verhindert, daß bei einem Rasierapparat oder einer Haarschneidemaschine unvorhergesehen Haare schmerzhaft eingeklemmt werden.

## Patentansprüche

1. Batteriebetriebener elektrischer Rasierapparat oder Haarschneidemaschine mit einer Detektion des Entladezustandes der Batterie (B),
dadurch gekennzeichnet,
daß bei einem bestimmten detektierten Entladezustand der Batterie (B) eine Abschaltung des Motors (2) des elektrischen Rasierapparates oder der Haarschneidemaschine erfolgt, indem dessen Drehzahl derart stufenweise oder kontinuierlich bis auf Null reduziert wird, daß keine Haare eingeklemmt werden können.

2. Rasierapparat oder Haarschneidemaschine nach Anspruch 1,
dadurch gekennzeichnet,
daß zur Abschaltung des Motors (2) ein Pulsbreitenmodulator (4) angesteuert wird, der das Tastverhältnis der Steuerspannung für einen elektronischen Schalter (21) reduziert, so daß die Motordrehzahl stufenweise oder kontinuierlich bis auf Null reduziert wird.

3. Rasierapparat oder Haarschneidemaschine nach Anspruch 1 oder 2,
dadurch gekennzeichnet,
daß die Reduzierung der Motordrehzahl linear mit der Zeit erfolgt.

4. Rasierapparat oder Haarschneidemaschine nach Anspruch 1 oder 2,
dadurch gekennzeichnet,
daß die Reduzierung der Motordrehzahl ähnlich dem Kurvenverlauf einer fallenden Batteriespannung kurz vor der vollständigen Entladung erfolgt.

## Claims

1. A battery-powered electric shaver or hair clipper having a detector for the charge status of the battery (B),
**characterized in that** on detection of a predetermined discharge status of the battery (B) the motor (2) of the electric shaver or hair clipper is turned off by reducing its rotational frequency in steps or continually down to zero in such manner that the risk that hairs could be snagged is eliminated.

2. The electric shaver or hair clipper according to claim 1,
**characterized in that** for turning off the motor (2) a pulse-duration modulator (4) is driven which reduces the pulse duty factor of the control voltage for an electronic switching device (21), so that the rotational frequency of the motor is reduced in steps or continually down to zero.

3. The electric shaver or hair clipper according to claim 1 or 2,
**characterized in that** the rotational frequency of the motor is reduced linearly with time.

4. The electric shaver or hair clipper according to claim 1 or 2,
**characterized in that** the rotational frequency of the motor is reduced similarly to a curve of a falling battery voltage shortly before deep depletion.

## Revendications

1. Rasoir électrique ou tondeuse électrique à cheveux, alimenté par batterie, avec détection de l'état de décharge de la batterie (B),
caractérisé en ce
que dans un certain état de décharge détecté de la batterie (B), un arrêt du moteur (2) du rasoir électrique ou de la tondeuse à cheveux est exécuté par le fait que sa vitesse de rotation est réduite à zéro d'une manière échelonnée ou continue, de telle sorte qu'aucun cheveu ne peut être coincé.

2. Rasoir ou tondeuse à cheveux selon la revendication 1, caractérisé en ce qu'un modulateur (4) de largeur d'impulsion est commandé pour l'arrêt du moteur (2), le modulateur réduisant le rapport de durée d'application dans le temps de la tension de commande pour l'interrupteur électronique (21) de telle sorte que la vitesse de rotation du moteur est réduite à zéro d'une manière échelonnée ou continue.

3. Rasoir ou tondeuse à cheveux selon la revendication 1 ou 2, caractérisé en ce
que la réduction de la vitesse de rotation du moteur s'effectue linéairement dans le temps.

4. Rasoir ou tondeuse à cheveux selon la revendication 1 ou 2, caractérisé en ce
que la réduction de la vitesse de rotation du moteur s'effectue d'une manière similaire à une allure de courbe d'une tension de batterie qui baisse, peu avant la décharge complète.
